Europäisches Patentamt

European Patent Office

Office européen des brevets

(19)

(11) Veröffentlichungsnummer: **0 000 701**
**B1**

(12) **EUROPÄISCHE PATENTSCHRIFT**

(45) Veröffentlichungstag der Patentschrift: **16.09.81**

(21) Anmeldenummer: **78100336.3**

(22) Anmeldetag: **10.07.78**

(51) Int. Cl.³: **H 01 L 21/302,**
**C 09 K 13/04**

(54) Verfahren zur Entfernung von Siliciumdioxidrückständen von einer Halbleiteroberfläche.

(30) Priorität: **15.08.77 US 824382**

(43) Veröffentlichungstag der Anmeldung:
**21.02.79 Patentblatt 79/4**

(45) Bekanntmachung des Hinweises auf die Patenterteilung:
**16.09.81 Patentblatt 81/37**

(84) Benannte Vertragsstaaten:
**DE FR GB**

(56) Entgegenhaltungen:
**DE - A - 1 614 103**
**US - A - 3 715 249**
**US - A - 3 728 154**
**US - A - 3 728 267**
**FR - A - 1 335 652**
**DE - A - 2 706 519**

**CHEMICAL ABSTRACTS, vol. 83,**
**no. 12, September 22, 1975**
**Columbus, Ohio**
**E. G. ZAUGOLNIKOVA: "Effect of the**
**composition of materials for cleaning the**
**surface of silicon on the properties of**
**silicondioxide" Zusammenfassung**
**no. 107036g, Seite 643**

(73) Patentinhaber: **International Business Machines Corporation**
**Armonk, N.Y. 10504 (US)**

(72) Erfinder: **Basi, Jagtar Singh**
**97 Nantucket Drive**
**Fishkill, N.Y. 12524 (US)**

(74) Vertreter: **Kreidler, Eva-Maria, Dr. rer. nat.**
**Schönaicher Strasse 220**
**D-7030 Böblingen (DE)**

Courier Press, Leamington Spa, England.

Verfahren zur Entfernung von Siliciumdioxidrückständen von einer Halbleiteroberfläche

Die Erfindung betrifft ein Verfahren zur Entfernung von Siliciumdioxidrückständen von einer Halbleiteroberfläche nach dem Polieren mit einem siliciumdioxidhaltigen Poliermittel.

Im Zuge der Mikrominiaturisierung elektronischer Schaltkreise hat das Bedürfnis nach glatten und reinen Halbleiteroberflächen ohne Beschädigungen erhebliche Bedeutung erlangt. Glatte polierte Oberflächen werden durch Anwendung eines Polierschlamms erhalten. Das Polieren mit Siliciumdioxid ist ein Beispiel für ein typisches Polierverfahren. Bei diesem Verfahren wird ein Polierschlamm mit einem Gehalt an einem abtragenden kolloidalen Siliciumdioxid, Natriumdichlorisocyanurat als Oxidationsmittel un Natriumcarbonat als basischem Bestandteil verwendet. Der pH-Wert des Polierschlamms liegt unterhalb 10. Nach dem Polieren ist es erforderlich, die polierte Oberfläche zu reinigen, um den Polierschlamm und andere Oberflächenverunreinigungen bei einem Minimum an chemischer oder mechanischer Oberflächenbeschädigung zu entfernen.

Nach der Beendigung des Polierverfahrens mit Siliciumdioxid, sind folgende Materialien von der Halbleiteroberfläche zu entfernen, um eine reine Oberfläche zu erhalten:

1. kolloidales Siliciumdioxid;

2. Natriumdichlorisocyanurat und dessen Reaktionsprodukte mit Natriumcarbonat;

3. Natriumcarbonat;

4. amorphes Siliciumdioxid;

5. andere metallische Verunreinigungen, die sich aus den Komponenten des Polierschlamms auf der Halbleiteroberfläche abgeschieden haben.

Bisher wurden verschiedene mechanische und chemische Verfahren angewendet, um die mit Siliciumdioxid oder einem metalloxidhaltigen Schlamm polierten Wafer zu reinigen. Diese Verfahren verursachen mechanische Beschädigungen, beachtliche Änderungen der Oberflächencharakteristika oder werden unter Anwendung von Chemikalien durchgeführt, die nicht unweltfreundlich und/oder aus hygienischen Gründen nicht brauchbar sind.

In dem in der deutschen Offenlegungsschrift 27 06 519 beschriebenen Verfahren wird zur Reinigung der Halbleiteroberfläche eine Behandlung mit einem Oxidationsmittel, beispielsweise NaClO, gefolgt von einer Spülung mit Ammoniumhydroxid durchgeführt. In einem anderen Verfahren werden quaternäre Ammoniumsalze angewendet, um reine hydrophobe Halbleiteroberflächen ohne Beschädigung der Oberfläche zu erhalten.

Aufgabe der Erfindung ist die Bereitstellung eines umweltfreundlichen, sicheren und effektiven Verfahrens zur Entfernung von Siliciumdioxid-Poliermaterialien unter Erhalt einer reinen, hydrophilen, nicht beschädigten Halbleiteroberfläche.

Die Aufgabe der Erfindung wird gelöst durch ein Verfahren der eingangs genannten Art, das dadurch gekennzeichnet ist, daß die Halbleiteroberfläche mit einer wässrigen Phosphorsäurelösung behandelt und dann mit Wasser und einer wässrigen Ammoniumhydroxidlösung gespült wird.

In einer vorteilhaften Ausgestaltung der Erfindung wird die Halbleiteroberfläche nach der Behandlung mit Phosphorsäure zusätzlich mit einer wässrigen Schwefelsäurelösung behandelt und dann gespült.

Die Erfindung wird anhand der nachfolgenden speziellen Beschreibung und der Ausführungsbeispiele näher erläutert.

Der wässrige Schlamm auf Siliciumdioxidbasis, der zum Polieren von Halbleiteroberflächen verwendet wird, enthält kolloidales Siliciumdioxid als abtragendes Material, ein Oxidationsmittel wie Natriumdichlorisocyanurat und eines Base wie Natriumcarbonat.

Nach dem Polieren der Halbleiteroberfläche mit dem Siliciumdioxidschlamm ist die Oberfläche mit einem Rückstand aus kolloidalem Siliciumdioxid, amorphem Siliciumdioxid, Natriumcarbonat und Rückständen des Poliertuchs verunreinigt. Eine Spülung mit Wasser allein genügt nicht zur Entfernung der Verunreinigungen.

Es ist bekannt, daß Siliciumdioxid mit Phosphorsäure bei hohen Temperaturen (über 200°C) reagiert unter Ausbildung verschiedener Siliciumphosphate je nach den Reaktionsbedingungen (s. H. R. Levi et al; Z. Krist 92, 191 1935). Es ist auch bekannt, daß festes Silicagel mit verdünnter Phosphorsäure reagiert unter Ausbildung eines Oberflächenfilms, welcher die Löslichkeit des Siliciumdioxids sowohl in Wasser wie auch in Phosphorsäure verzögert (s. B. M. Mitsynk, Zh. Neorg Khim, 17 903 (1972)). Überraschend im Hinblick auf diese Veröffentlichungen wurde nunmehr gefunden, daß kolloidales Siliciumdioxid anders als festes Siliciumdioxid sich schnell in verdünnter Phosphorsäure bei Zimmertemperatur löst, so daß die Wafer leicht und ohne Beschädigung gereinigt werden können. Die hydrophobe Natur der Oberfläche wird in eine hydrophile umgewandelt, was wahrscheinlich auf die in saurem Medium stattfindende Hydrolyse der Siloxangruppen an der Siliciumoberfläche zurückzuführen ist. Die Hydrolyse an der Oberfläche und das Auflösen werden durch eine Schwefelsäurebehandlung, wie in Beispiel 1 dargestellt ist, beschleunigt. Das Verfahren gestattet die Aufbewahrung der Halbleiter vor der Reinigung, indem sie in eine verdünnte wässrige Phosphorsäurelösung gebracht werden, ohne daß Wasserflecken oder Schleier auf der Halbleiteroberfläche im Anschluß an die Reinigung gebildet werden.

Geeignete Phosphorsäurekonzentrationen in Wasser liegen im Bereich von 10 bis 50 Gew.%, vorzugsweise im Bereich von 20 bis 30 Gew.% Nachdem der Poliervorgang beendigt ist, werden die Halbleitersubstrate aus der Poliermaschine entfernt, ohne daß man sie trocknen läßt. Sie können dann unmittelbar gereinigt oder in einer Phosphorsäurereinigungslösung für längere Zeit (beispielsweise 24 Stunden) aufbewahrt und danach leicht und wirkungsvoll nach dem erfindungsgemäßen Verfahren gereinigt werden unter Erhalt einer schleierfreien Oberfläche. Zur Reinigung der Substrate werden diese zuerst besprüht oder etwa 5 bis 10 Minuten lang bei Umgebungstemperaturen (20 bis 30°C) in eine wässrige Phosphorsäurelösung getaucht und dann in Wasser gespült, um die lose anhaftenden Teilchen und die Phosphorsäurelösung zu entfernen. Danach werden die Substrate vorzugsweise mit einer verdünnten (20 bis 30 gew.%igen) wässrigen Schwefelsäurelösung behandelt, welche die Auflösung irgendwelcher Siliciumphosphate bewirkt und die Oberflächenhydrolyse begünstigt. Alternativ hierzu kann die Schwefelsäurelösung zu der Phosphorsäurelösung zugegeben werden. Für den Fall, daß Schwermetallverunreinigungen vorhanden sind, werden die mit Wasser gespülten Substrate mit verdünnter wässriger Ammoniumhydroxidlösung, die etwa 3 bis 5 gew.%ig ist, gespült (getaucht oder besprüht). Ein Komplexbildner kann auch zu der Ammoniumhydroxidlösung zugegeben werden, um die Entfernung der Ionen zu begünstigen. Der Halbleiterkörper wird dann in Wasser gespült und durch Bürsten in Wasser gereinigt.

In den nachfolgenden Ausführungsbeispielen sind die Konzentrationen, wenn nicht anders angegeben, in Gewichtsteilen.

### Beispiel 1

Frisch polierte und gespülte Siliciumwafer werden 10 Minuten lang in eine wässrige, 21 %ige Phosphorsäurelösung gegeben und dann entfernt und zwei Minuten lang in fliessendem deionisiertem Wasser gespült. Die Wafer werden fünf Minuten lang in 20 gew.%ige wässrige Schwefelsäure gegeben, zwei Minuten lang mit deionisiertem Wasser und anschließend 30 Sekunden lang mit einer 3 %igen wässrigen Ammoniumhydroxidlösung gespült. Sie werden dann mit deionisiertem Wasser besprüht und in heißer Stickstoffatmosphäre trockengeschleudert. Dieser Vorgang wird in einer automatischen Spül-Trocknungsvorrichtung durchgeführt. Die Wafer werden durch Bürsten oder mit einem Filz mit deionisiertem Wasser gereinigt. Die Prüfung der Oberfläche unter einer hellen Lampe ergab, daß kein Siliciumdioxid oder andere teilchenförmige Verunreinigungen vorhanden waren.

Das zuvor angegebene Verfahren kann dahingehend modifiziert werden, daß zwei Schritte eliminiert werden bei Anwendung einer wässrigen Lösung mit einem Gehalt an 21 Gew.% Phosphorsäure und 20 Gew.% Schwefelsäure in einem Schritt. Dies macht die separate Anwendung der Schwefelsäure und die zweite Wasserspülung überflüssig.

### Beispiel 2

Siliciumwafer, die mit einem Siliciumdioxidpolierschlamm poliert und dann mit Wasser gespült wurden, werden von der Poliermaschine entfernt und ohne vorherige Trocknung fünf Minuten lang bei Zimmertemperatur in eine 20 gew.%ige wässrige Phosphorsäurelösung gegeben. Die Wafer werden aus der Lösung entfernt und drei Minuten lang mit deionisiertem Wasser gespült und dann 30 Sekunden lang in einer Sprühvorrichtung mit einer wässrigen 3 gew.%igen Ammoniumhydroxidlösung und anschließend mit deionisiertem Wasser besprüht und dann in heißer Stickstoffatmosphäre durch Schleudern getrocknet. Der gesamte Spülprozeß wird in einem Sprühtrocknungsautomaten durchgeführt und dauert ungefähr 10 Minuten. Die Wafer sind nach dem Reinigungsprozeß hydrophil (d.h. Wasser benetzt die Oberfläche). Die Waferoberflächen sind rein und ohne Schleier. Eine emissionsspektrographische Analyse an den gereinigten Wafern zeigt vernachlässigbare Mengen von Al, Ca, Cr, Cu, Fe, Mg, Na und Ti.

Der zuvor angegebene Reinigungsprozeß wurde an Wafern wiederholt, welche 24 Stunden lang in der Reinigungslösung aufbewahrt worden waren. Er führte zu reinen Oberflächen ohne Spuren von Wasser und Flecken auf den Wafern.

Das beschreibene Verfahren führt zu polierten Halbleiteroberflächen, welche sauber, hydrophil und ohne Schleier sind. Die Oberflächen werden durch den Reinigungsprozeß nicht abgebaut, und in dem Verfahren werden nur umweltfreundliche und hygienische Materialien verwendet. Die Halbleitermaterialien können vor der Reinigung bis zu 24 Stunden in verdünnter Phosphorsäurelösung aufbewahrt werden, ohne daß die Oberfläche in irgendeiner Weise beschädigt wird. Es ist nur eine leichte Bürstenreinigung erforderlich, um irgendwelche Partikel von den gereinigten Oberflächen zu entfernen.

### Patentansprüche

1. Verfahren zur Enfernung von Siliciumdioxidrückständen von einer Halbleiteroberfläche nach dem Polieren mit einem siliciumdioxidhaltigen Poliermittel, dadurch gekennzeichnet, daß die Halbleiteroberfläche mit einer wässrigen Phosphorsäurelösung behandelt und dann mit Wasser und einer wässrigen Ammoniumhydroxidlösung gespült wird.

2. Verfahren nach Anspruch 1, dadurch gekennzeichnet, daß die Halbleiteroberfläche nach der Behandlung mit Phosphorsäure zusätzlich mit einer wässrigen Schwefelsäurelösung behandelt wird.

3. Verfahren nach Anspruch 1, dadurch gekennzeichnet, daß die Halbleiteroberfläche mit einer Lösung mit einem Gehalt an Phosphorsäure und Schwefelsäure behandelt wird.

4. Verfahren nach den Ansprüchen 1 bis 3, dadurch gekennzeichnet, daß Säurelösungen mit einem Gehalt an 20 bis 30 Gew.% der jeweiligen Säure verwendet werden.

5. Verfahren nach Anspruch 1, dadurch gekennzeichnet, daß eine 3 gew.%ige Ammoniumhydroxidlösung verwendet wird.

6. Verfahren nach den Ansprüchen 1 bis 5, dadurch gekennzeichnet, daß kolloidale oder amorphe Siliciumdioxidrückstände von der Halbleiteroberfläche entfernt werden.

## Revendications

1. Procédé d'élimination de résidus de dioxyde de silicium de la surface d'un semiconducteur après polissage à l'aide d'un agent de polissage contenant du dioxyde de silicium, caractérisé en ce que la surface semiconductrice est traitée avec une solution aqueuse d'acide phosphorique et ensuite rincée avec de l'eau et une solution aqueuse d'hydroxyde d'ammonium.

2. Procédé selon la revendication 1, caractérisé en ce qu'après le traitement à l'acide phosphorique la surface semi-conductrice est en outre traitée avec une solution aqueuse d'acide sulfurique.

3. Procédé selon la revendication 1, caractérisé en ce que la surface semiconductrice est traitée avec une solution contenant de l'acide phosphorique et de l'acide sulfurique.

4. Procédé selon l'une quelconque des revendications I à 3, caractérisé en ce que les solutions d'acide utilisées contiennent 20 à 30% du poids de l'acide respectif.

5. Procédé selon la revendication 1, caractérisé en ce qu'une solution d'hydroxyde d'ammonium à 3% en poids est utilisée.

6. Procédé selon l'une quelconque des revendications 1 à 5, caractérisé en ce que les résidus de dioxyde de silicium colloïdaux et amorphes sont éliminés de la surface semiconductrice.

## Claims

1. Method of removing silicon dioxide residues from a semiconductor surface after polishing with a silicon dioxide-containing polishing agent, characterized in that the semiconductor surface is treated with an aqueous phosphoric acid solution and subsequently rinsed with water and an aqueous ammonium hydroxide solution.

2. Method as claimed in claim 1, characterized in that after the treatment with phosphoric acid the semiconductor surface is additionally treated with an aqueous sulfuric acid solution.

3. Method as claimed in claim 1, characterized in that the semiconductor surface is treated with a solution containing phosphoric acid and sulfuric acid.

4. Method as claimed in claims 1 to 3, characterized in that acid solutions containing 20 to 30 percent by weight of the respective acid are used.

5. Method as claimed in claim 1, characterized in that an ammonium hydroxide solution of 3 percent by weight is used.

6. Method as claimed in claims 1 to 5, characterized in that colloidal or amorphous silicon dioxide residues are removed from the semiconductor substrate.